# EUROPÄISCHE PATENTSCHRIFT

(11) **EP 2 474 019 B1**
(45) Veröffentlichungstag und Bekanntmachung des Hinweises auf die Patenterteilung: **19.08.2015**
(21) Anmeldenummer: 10750065.4
(22) Anmeldetag: 31.08.2010
(51) Int. Cl.: H01J 37/16, G21K 5/10, H01J 37/31, H01J 37/30, B23K 15/06, B23K 15/00

(54) **TEILCHENSTRAHLBEARBEITUNGSVORRICHTUNG WIE EINE ELEKTRONENSTRAHLBEARBEITUNGSVORRICHTUNG**
PARTICLE BEAM PROCESSING DEVICE SUCH AS AN ELECTRON BEAM PROCESSING DEVICE
DISPOSITIF D'USINAGE PAR FAISCEAU PARTICULAIRE TEL QU'UN DISPOSITIF D'USINAGE PAR FAISCEAU ÉLECTRONIQUE

(30) Priorität: 01.09.2009 DE 102009039621; 05.11.2009 DE 202009015125 U
(43) Veröffentlichungstag der Anmeldung: 11.07.2012
(73) Patentinhaber: Global Beam Technologies AG, 82216 Maisach (DE)
(72) Erfinder: VOKURKA, Franz, 39019 Dorf Tirol (Meran) (IT)
(74) Vertreter: Kramer Barske Schmidtchen Patentanwälte PartG mbB
(86) Internationale Anmeldenummer: PCT/EP2010/005350
(87) Internationale Veröffentlichungsnummer: WO 2011/026607

(56) Entgegenhaltungen:
- DE-A1-102006 047 705
- DE-U1- 29 520 791
- FR-A1- 2 372 509
- GB-A- 1 404 931
- US-A- 2 771 568
- US-A- 3 588 442
- US-A- 3 761 676
- US-A- 5 575 176
- US-A- 5 700 988
- US-A1- 2009 010 772

## Beschreibung

Die vorliegende Erfindung bezieht sich auf eine Teilchenstrahlbearbeitungsvorrichtung nach dem Oberbegriff des Anspruchs 1.

Eine Teilchenstrahlbearbeitungsvorrichtung nach dem Oberbegriff des Anspruchs 1 ist aus der DE 19 21 226 B2 (entspricht der US 3,588,442) bekannt. Ein Beispiel für eine Teilchenstrahlbearbeitungsvorrichtung ist eine Elektronenstrahlbearbeitungsvorrichtung, bei der ein Elektronenstrahlerzeuger zur Bearbeitung von Werkstücken in einer Vakuumkammer eingesetzt wird. Elektronenstrahlerzeuger sind allgemein bekannt (z.B. US 5,089,686).

Die US 5,700,988 A offenbart eine Teilchenstrahlbearbeitungsvorrichtung, die an einem Bauteil eines Kernreaktors angebracht werden kann, so dass zwischen der Vorrichtung und dem Bauteil eine evakuierbare Kammer ausgebildet wird. Die Teilchenstrahlbearbeitungsvorrichtung besteht aus einer Abdeckung, die einen Teilchenstrahlgenerator trägt und an dem Bauteil des Kernreaktors befestigt wird. Der Teilchenstrahlgenerator ist auf der dem Bauteil abgewandten Seite der Abdeckung angebracht und kann mittels exzentrischer Scheiben parallel zu der Abdeckung verfahren werden.

Die FR 2 372 509 A1 offenbart ebenfalls eine Abdeckung zur Bearbeitung eines Werkstücks unter einem Vakuum. Der auf der dem Werkstück abgewandten Seite der Abdeckung vorgesehene Teilchenstrahlgenerator kann ebenfalls über mehrere Exzenterscheiben relativ zu dem Werkstück bewegt werden.

Die US 5,575,176 A offenbart eine Vorrichtung zum Positionieren von Objekten in einer abgedichteten Kammer. Ein inneres und ein äußeres drehbares Element sind unabhängig voneinander drehbar. Das zu positionierende Objekt in der abgedichteten Kammer ist exzentrisch an der inneren Endfläche des inneren Elements montiert. Eine relative Drehung des inneren und des äußeren Elements ermöglicht eine zweidimensionale Objektpositionierung.

Aufgabe der Erfindung ist es, bekannte Teilchenstrahlbearbeitungsvorrichtungen im Hinblick auf ihre praktische Einsetzbarkeit zu verbessern.

Diese Aufgabe wird gelöst durch eine Teilchenstrahlbearbeitungsvorrichtung nach Anspruch 1.

Weiterbildungen der Erfindung sind in den Unteransprüchen angegeben.

Ein Verfahren eines Teilchenstrahlgenerators innerhalb eines evakuierbaren Kammervolumens der Vakuumkammer, wahlweise mit einer Bewegung des Teilchenstrahlgenerators über zwei oder mehr exzentrisch drehbare Abdeckplatten, ermöglicht eine drastische Verringerung des Kammervolumens bei Erhaltung einer variablen Werkstückbearbeitung.

Das Vorsehen eines Druckausgleichmittels ermöglicht die präzise Steuerung der Bewegung eines Teilchenstrahlgenerators, der z.B. über zwei oder mehr exzentrisch drehbare Abdeckungen bewegt wird.

Das Vorsehen einer Begrenzung der Drehung z.B. eines Verschlusses einer Öffnung in einer der exzentrisch drehbaren Abdeckungen ermöglicht die sichere Verhinderung der Beschädigung von Zufuhrleitungen und Ähnlichem für einen z.B. in der Vakuumkammer verfahrenen Teilchenstrahlgenerator.

Weitere Merkmale und Zweckmäßigkeiten ergeben sich aus der Beschreibung von Ausführungsbeispielen anhand der Figuren. Von den Figuren zeigen:
- Fig. 1: eine erste Ausführungsform einer Teilchenstrahlbearbeitungsvorrichtung in einer senkrechten Schnittansicht;
- Fig. 2: in a) eine Draufsicht auf eine zweite Ausführungsform, und in b) einen Schnitt entlang A-A in Fig. 2a) entsprechend des Schnittes aus Fig. 1;
- Fig. 3: eine Schnittansicht eines Teils der Ausführungsform aus Fig. 1;
- Fig. 4: eine Schnittansicht einer Druckkompensationsvorrichtung;
- Fig. 5: in a) eine Ausführungsform mit Druckkraftreduzierung für ein Vertikalfahrwerk, die eine Modifikation der ersten Ausführungsform ist, und in b) eine weitere Modifikation der ersten Ausführungsform mit Vertikalfahrwerk und Druckkompensation;
- Fig. 6: eine senkrechte Schnittansicht eines Teils einer weiteren Ausführungsform einer Teilchenstrahlbearbeitungsvorrichtung;
- Fig. 7: eine schematische Schnittansicht eines Teils einer weiteren Ausführungsform einer Teilchenstrahlbearbeitungsvorrichtung sowie eine schematische Draufsicht auf eine Exzenterscheibenanordnung der Ausführungsform;
- Fig. 8: eine Modifikation einer Abdeckung einer Exzenterscheibenanordnung;
- Fig. 9: eine schematische Draufsicht auf eine Modifikation der Exzenterscheibenanordnung aus Fig. 7; und
- Fig. 10: eine schematische Draufsicht auf eine Ausführungsform einer Teilchenstrahlbearbeitungsvorrichtung zur Bearbeitung langer Werkstücke.

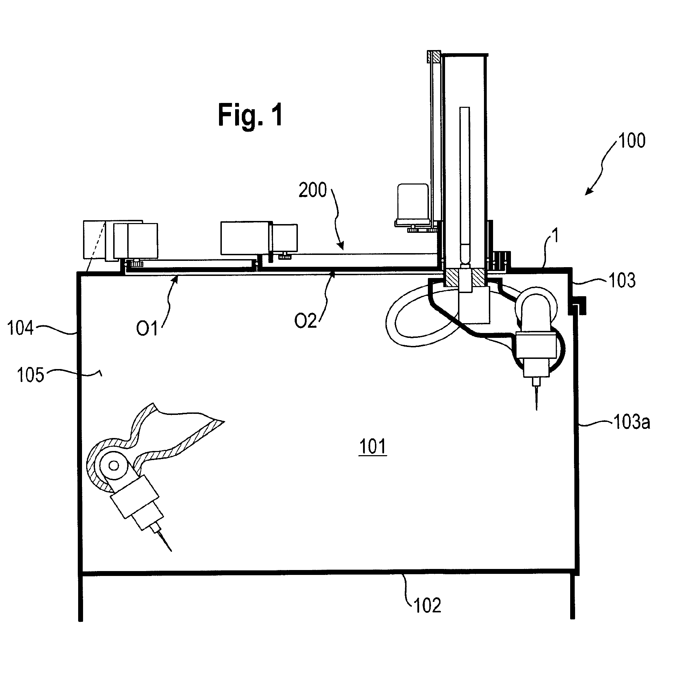

Nachfolgend werden Ausführungsformen einer Elektronenstrahlbearbeitungsvorrichtung als ein Beispiel für eine Teilchenstrahlbearbeitungsvorrichtung unter Bezugnahme auf die Fig. 1 bis 10 beschrieben.

Fig. 1 zeigt eine Elektronenstrahlbearbeitungsvorrichtung 100 in einem senkrechten Querschnitt. Die Elektronenstrahlbearbeitungsvorrichtung 100 weist eine Vakuumkammer 101 auf. Die Vakuumkammer 101 wird begrenzt von einer bodenseitigen Wand 102, einer Vorderwand 103, einer Rückwand 104, Seitenwänden 105 und einer oberen Kammerwand 1. Die Vorderwand 103 weist eine Be-/Entladeöffnung auf, die mit einem Verschluss 103a wie einem Kipptor oder Schiebetor oder Ähnlichem vakuumdicht verschließbar ist. Die obere Kammerwand 1 wird nachfolgend einfach als Kammerwand 1 bezeichnet, da es nicht darauf ankommt, ob die entsprechende Kammerwand die obere oder eine andere der Kammerwände ist.

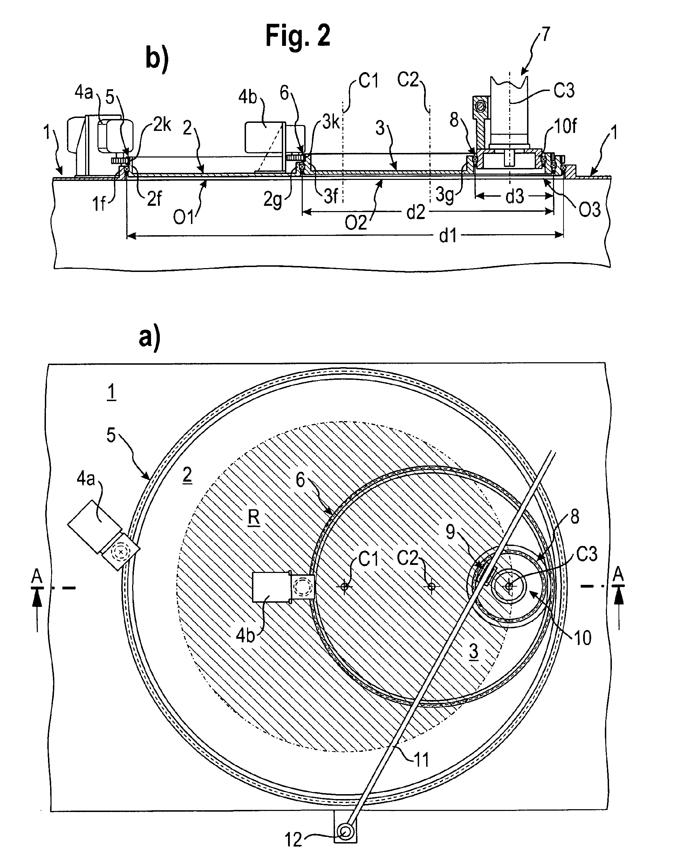

Die Kammerwand 1 weist eine erste Öffnung O1 auf, die in der Kammerwand 1 ausgebildet ist. Die Öffnung O1 ist bei den gezeigten Ausführungsformen kreisförmig (siehe Fig. 2a). Am Rand der Öffnung O1 ist ein Flansch 1 f ausgebildet, der von der Vakuumwand 1 nach außen vorsteht. Die erste Öffnung O1 ist bei den gezeigten Ausführungsformen durch eine Exzenterscheibenanordnung 200 verschlossen. Die Exzenterscheibenanordnung 200 weist eine erste (äußere) Abdeckung 2, die bei der gezeigten Ausführungsform als äußere Drehscheibe ausgebildet ist, eine zweite (innere) Abdeckung 3, die bei der gezeigten Ausführungsform als exzentrisch angeordnete innere Drehscheibe ausgebildet ist, und eine dritte Abdeckung bzw. einen Verschluss 10, der bei der in Fig. 2 gezeigten Ausführungsform als Drehteller für den Aufbau eines Elektronenstrahlgenerators 7 ausgebildet ist, auf. Dabei weist die erste Abdeckung 2 eine zweite Öffnung 02 auf. Bei den gezeigten Ausführungsformen ist auch die zweite Öffnung 02 kreisförmig. Die zweite Abdeckung 3 weist eine dritte Öffnung 03 auf, die bei den gezeigten Ausführungsformen wiederum kreisförmig ist.

Die erste Abdeckung 2, d.h. die äußere Drehscheibe, ist ebenfalls kreisförmig mit einem Außendurchmesser, der dem Innendurchmesser der ersten Öffnung O1 (mit Spielraum für eine Abdichtung) entspricht. Daraus folgt, dass sowohl die erste Öffnung O1 als auch die erste Abdeckung 2 senkrechte Mittelachsen aufweisen, die in diesem Fall in der Achse C1 zusammenfallen.

Die zweite Öffnung 02, die ebenfalls kreisförmig ist, weist eine zweite Mittelachse C2 auf. Die erste und die zweite Öffnung O1, 02 sind exzentrisch angeordnet, d.h. die Achsen C1 und C2 verlaufen parallel, aber mit Abstand voneinander.

Bei den gezeigten Ausführungsformen ist die zweite Abdeckung 3 wiederum als kreisförmige Drehscheibe ausgebildet, deren Außendurchmesser (mit Spiel zur Abdichtung) dem Innendurchmesser der zweiten Öffnung 02 entspricht. Daraus folgt, dass auch die Mittelachse der zweiten Öffnung 02 mit der Mittelachse der zweiten Abdeckung 3 zusammenfällt, in diesem Fall in der Achse C2.

Die dritte Öffnung 03, die ebenfalls kreisrund ist, weist eine dritte Mittelachse C3 auf. Die dritte Öffnung ist wiederum exzentrisch zu der ersten und zweiten Öffnung O1, 02 angeordnet, d.h. die Achse C3 ist parallel zu, aber mit Abständen von den Achsen C1 und C2 angeordnet.

Die dritte Öffnung 03 weist einen dritten Innendurchmesser d3 auf. Der Verschluss 10, der in Form eines Drehtellers für den Aufbau des Elektronenstrahlgenerators (Fig. 2) oder in Form einer Vorrichtung zum vertikalen Verfahren und Schwenken und Drehen eines in der Vakuumkammer 101 angeordneten Elektronenstrahlgenerators 7 ausgebildet sein kann, weist wiederum einen Außendurchmesser, der (mit Spiel zur Abdichtung) dem dritten Innendurchmesser d3 entspricht, auf.

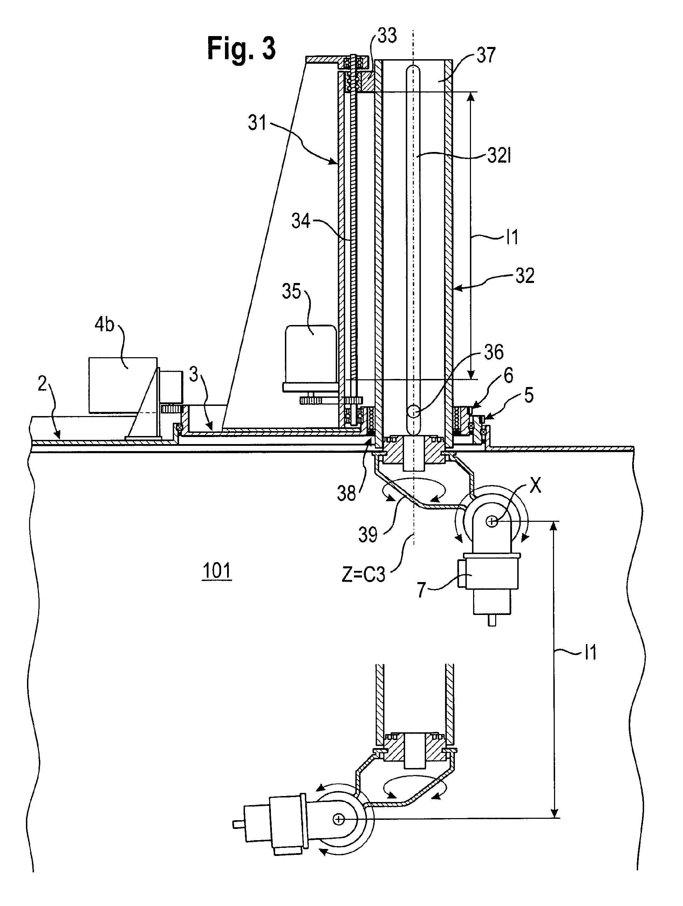

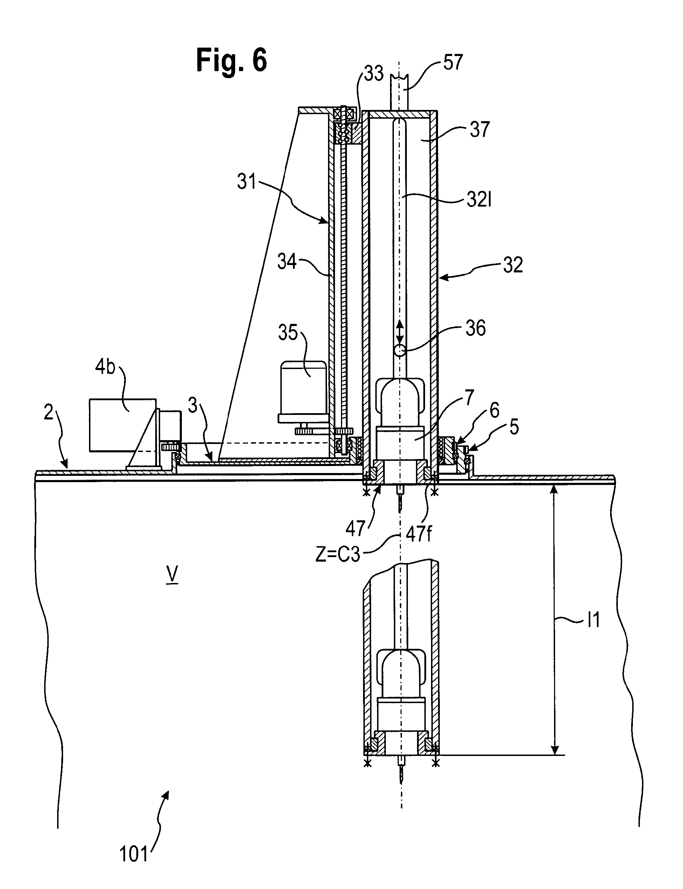

Wie hierin verwendet, bedeutet der Ausdruck "in der Vakuumkammer" bzw. "in dem Kammervolumen der Vakuumkammer" nicht zwangsläufig, dass sich der Elektronenstrahlgenerator 7 in dem in der Vakuumkammer erzeugten Vakuum befindet, sondern vielmehr, dass er in dem durch die Kammerwände begrenzten Raum (dem evakuierbaren Kammervolumen) positioniert ist bzw. darin verfahren wird. Dabei kann der Elektronenstrahlgenerator 7 wie in Fig. 3 gezeigt in einer Null- bzw. Ausgangsstellung, in der er in der Nähe der Kammerwand 1 positioniert ist, innerhalb des evakuierbaren Kammervolumens angeordnet sein und aus der Nullstellung in dem evakuierbaren Kammervolumen in einer ersten Richtung Z verfahren werden. Alternativ kann der Elektronenstrahlgenerator 7 wie in Fig. 6 gezeigt in einer Nullstellung außerhalb des evakuierbaren Kammervolumens V angeordnet sein und aus der Nullstellung durch eine Öffnung in der Kammerwand in dem evakuierbaren Kammervolumen V in der ersten Richtung Z verfahren werden. Bei der Ausführungsform aus Fig. 6 befindet sich der Elektronenstrahlgenerator 7 nicht in dem in der Vakuumkammer herrschenden Vakuum, sondern in einem gegenüber der Vakuumkammer abgeschlossenen Aufnahmeraum der Verfahrvorrichtung, in dem ein unterschiedlicher Druck, z.B. Atmosphärendruck, herrschen kann.

Die Exzenterscheibenanordnung 200 weist eine im eingebauten Zustand (siehe Fig. 1) der Vakuumkammer 101 zugewandte Seite (nachfolgend Innenseite) und eine im eingebauten Zustand der Vakuumkammer 101 abgewandte Seite (nachfolgend Außenseite) auf. Auf der Außenseite der ersten Abdeckung 2 ist ein nach außen vorstehender Flansch 2f vorgesehen. Der Flansch 2f weist einen Zahnkranz 2k, der am äußeren Umfang des Flansches verläuft, auf. Der Flansch 1f der Kammerwand 1 und der Flansch 2f ersten Abdeckung 2 dienen zum Halten der Lagerung und der Dichtung der ersten Abdeckung 2 gegenüber der Kammerwand 1 und somit der Dichtung der Vakuumkammer 101 gegenüber der Atmosphäre.

Die erste Abdeckung 2 weist an dem die zweite Öffnung 02 umgebenden Rand einen zweiten Flansch 2g, der zur Außenseite vorsteht, auf. Die zweite Abdeckung 3 weist an ihrem Außenrand wiederum einen nach außen vorstehenden Flansch 3f auf. An dem äußeren Umfang des Flansches 3f ist wiederum ein Zahnkranz 3k umlaufend ausgebildet. Die Flansche 2g und 3f dienen wiederum, analog den Flanschen 1f und 2f, zum Halten der Lagerung und Dichtung für die zweite Abdeckung 3 in der ersten Abdeckung 2.

Die zweite Abdeckung 3 weist wiederum an dem die dritte Öffnung 03 umgebenden Rand einen nach außen vorstehenden Flansch 3g auf.

Bei der in Fig. 2 gezeigten Ausführungsform weist der Verschluss 10, d.h. der Drehteller für den Aufbau des Elektronenstrahlgenerators 7, ebenfalls einen Flansch 10f auf. Die Flansche 10f und 3g dienen wiederum zur Halterung der Lagerung und der Dichtung des Verschlusses 10 gegenüber der zweiten Abdeckung 3.

Bei der in Fig. 1 und 3 gezeigten Ausführungsform dient die Außenwand eines vertikal verschiebbaren Rohrs 32 als Gegenstück zum Flansch 3e, d.h. als Ersatz für den Flansch 10f. Das Rohr 32 ist nur ein Beispiel für einen Teil einer Linearbewegungsvorrichtung, der dazu angepasst ist, den Teilchenstrahlgenerator 7 in dem evakuierbaren Kammervolumen der Vakuumkammer 101 zu verfahren. Anstelle des Rohrs 32 können auch andere Elemente/Teile wie zum Beispiel Stangen, Teleskopanordnungen, etc. vorgesehen sein.

Die derart ausgebildete Exzenterscheibenanordnung 200 ist in und über der ersten Öffnung O1 der Kammerwand 1 derart angeordnet, dass die Öffnung O1 vakuumdicht gegenüber der Atmosphäre verschlossen ist, wie in den Fig. 1 bis 3 gut zu erkennen ist.

Auf der Kammerwand 1 ist ein Antrieb 4a wie ein Servomotor, der über ein Ritzel in den Zahnkranz 2k eingreift, angeordnet. Derart bilden der Zahnkranz 2k, die Flansche 1f und 2f und die zugehörigen Lager und Dichtungen eine dichtende Drehlagerung 5 der ersten Abdichtung 2.

Auf der ersten Abdeckung 2 ist ein weiterer Antrieb 4b befestigt, der über ein Ritzel in den Zahnkranz 3k an dem Flansch 3f der zweiten Abdeckung 3 zum Antrieb desselben eingreift. Derart bilden der Zahnkranz 3k, die Flansche 2g und 3f und die entsprechenden Lager und Dichtungen wiederum eine dichtende Drehlagerung 6 für die zweite Abdeckung 3.

Bei der in Fig. 2 gezeigten Ausführungsform ist der Elektronenstrahlgenerator 7 auf der Außenseite des Verschlusses 10 vakuumdicht aufgesetzt, so dass der von ihm erzeugte Elektronenstrahl entlang der Achse C3 emittiert werden kann. Der Verschluss (Drehteller) 10 wird über eine dichtende Drehlagerung 8, die u.a. die Flansche 3g und 10f aufweist, wiederum vakuumdicht gegenüber der Atmosphäre gehalten.

Durch die genannte Anordnung ist es möglich, die erste Abdeckung 2 (=äußere Drehscheibe) zur Drehung um die Achse C1 anzutreiben. Weiterhin ist es möglich, die zweite Abdeckung 3 zur Drehung um die exzentrische Drehachse C2 anzutreiben.

Da ein Elektronenstrahlgenerator üblicherweise über Versorgungskabel und Ähnliches mit dem notwendigen Strom und gegebenenfalls Kühlmitteln etc. versorgt wird, ist es empfehlenswert, eine übermäßige Drehung des Elektronenstrahlgenerators um seine Längsachse (die Achse C3) und damit ein Verdrehen bzw. eine Drehung der Versorgungskabel und anderer Zufuhrleitungen zu verhindern. Daher ist bei der gezeigten Ausführungsform in Fig. 2 an dem Drehteller eine Führungseinheit 9 mit Linearlagern vorgesehen. In den Linearlagern ist eine Verbindungsund Führungsstange 11 längsverschiebbar gehalten, die mit einem Ende an der Vakuumkammer 101 schwenkbar befestigt ist. Die Führungsstange 11, die über ein Lager 12 in einer Ebene senkrecht zu den Achsen C1, C2, C3 schwenkbar ist, kann derart eine Drehung des Elektronenstrahlgenerators um die Achse C3 um mehr als ca. 90° (bei der gezeigten Ausführungsform) verhindern. Der Winkel kann je nach Anordnung der Stange variiert werden, und es können auch andere Vorrichtungen zur Begrenzung einer solchen Drehung, wie z.B. Anschläge oder Ähnliches, vorgesehen sein. Alternativ ist eine Begrenzung der entsprechenden Drehung durch eine CNC-Steuerung der Maschine möglich.

Bei der in Fig. 2 gezeigten Ausführungsform ist der Elektronenstrahlgenerator 7 außerhalb der Vakuumkammer 101 angeordnet.

Damit ist es, falls die mit dem Elektronenstrahlgenerator 7 zu bearbeitenden Werkstücke in verschiedenen Dimensionen und Richtungen bearbeitet werden sollen, notwendig, entsprechenden Werkstückbewegungsvorrichtungen (Manipulatoren) in der Vakuumkammer 101 vorzusehen. Das führt zwangsläufig zu einem vergleichsweise großen Volumen der Vakuumkammer 101, da diese neben dem Volumen des Werkstücks zusätzlich die üblicherweise voluminösen Manipulatoren wie Portale und Ähnliches aufnehmen muss. Bei der in den Fig. 1 und 3 gezeigten Ausführungsform ist der Elektronenstrahlgenerator in der Vakuumkammer 101 angeordnet. Der Verschluss 10 weist dabei ein Rohr 32 als einen Teil einer Linearbewegungsvorrichtung zum Verfahren des Elektronenstrahlgenerators auf, das längs der Achse C3 (=Z) über einen Weg 11 in der Z-Richtung längsverschiebbar ist. An dem in der Vakuumkammer 101 befindlichen (kammerseitigen) Ende des Rohrs 32 ist der Elektronenstrahlgenerator 7 über eine Dreh- und Schwenkvorrichtung 39 befestigt. Die Dreh- und Schwenkvorrichtung 39 ist zur Drehung um die Achse Z (=C3) und zur Schwenkung des Generators 7 um eine Schwenkachse X, die senkrecht zu der Längsachse Z ist, ausgebildet. Durch das Rohrinnere 37 sind die Zufuhrleitungen zu der Dreh- und Schwenkvorrichtung 39 bzw. zu dem Elektronenstrahlgenerator 7 geführt.

Die Linearführung und Dichtung für das Rohr 32 ist in Fig. 3 mit 38 bezeichnet. In dem Rohr 32 ist eine Nut 321 vorgesehen, in die ein Stift 36 als Verdrehsicherung längsverschiebbar ist. Anders als mit der Verbindungsstange 11 aus Fig. 2 wird bei der in Fig. 3 gezeigten Ausführungsform ein übermäßiges Verdrehen der Zufuhrleitungen für den Elektronenstrahlgenerator 7 dadurch verhindert, dass die Dreh- und Schwenkvorrichtung 39 die Drehung durch Drehen des Generators 7 um die Achse Z kompensiert. Die Steuerung der Elektronenstrahlbearbeitungsvorrichtung wird dazu entsprechend programmiert.

Das lineare Verfahren des Rohrs 32 und damit des Generators 7 in der Vakuumkammer 101 wird bei der in den Fig. 1 und 3 gezeigten Ausführungsform wie folgt bewerkstelligt. Es ist ein Befestigungsgerüst 31 für eine Kugelspindel 34 und einen an dem Rohr 32 befestigten Hubbalken 33 mit Kugelspindelmutter vorgesehen. An dem Befestigungsgerüst 31 ist ein Antriebsmotor 35 für die Kugelspindel (Kugelspindelantrieb) vorgesehen. Dadurch kann das Rohr über den Verfahrweg 11 und damit der Elektronenstrahlgenerator 7 in der Vakuumkammer 101 über den Verfahrweg 11 in Richtung der Achse Z verfahren werden.

Durch die entsprechende Anordnung von zwei Exzenterscheiben 2, 3 ist es also möglich, einen außen auf der Exzenterscheibenanordnung montierten Elektronenstrahlgenerator 7 (Fig. 2) in der Draufsicht über einen Arbeitsbereich R zu bewegen, wie in Fig. 2a) schraffiert dargestellt ist.

Mit der in den Fig. 1 und 3 gezeigten Ausführungsform ist es, zumindest soweit die Achse X einen Abstand von der Achse Z aufweist, möglich, den Arbeitsradius r1 eines solchen Arbeitsbereiches noch um den Abstand der beiden Achsen zu vergrößern.

Diese Lösungen haben insbesondere für sogenannte Großkammern, d.h. Vakuumkammern mit Kammervolumen von ca. 1 m³ und größer, die Werkstücke mit Seitenlängen ab 600 bis 800 mm zur Bearbeitung aufnehmen können, erhebliche Vorteile.

Ganz besonders groß ist der Vorteil, wenn zusätzlich zu der Exzenterscheibenanordnung der Elektronenstrahlgenerator in dem evakuierbaren Kammervolumen verfahrbar ist. Dadurch wird ein Großteil der das Kammervolumen vergrößernden Werkstückbewegungsvorrichtungen überflüssig, da nun anstelle des Werkstücks der Elektronenstrahl für die dreidimensionale Bearbeitung bewegt werden kann. Gegenüber Elektronenstrahlbearbeitungsvorrichtungen, bei denen der Elektronenstrahlgenerator außen montiert ist, und die die Exzenterscheibenanordnung nicht aufweisen, können die Verfahrwege in horizontaler Richtung für das in der Kammer befindliche Werkstück um ca. 40 bis 50% reduziert werden.

Gegenüber einer Lösung, bei der der Elektronenstrahlgenerator nicht verfahrbar in der Kammer angeordnet ist, und bei der das Werkstück mittels eines Portals in der Kammer bewegt wird, können zusätzlich ca. 40 bis 50% des Kammervolumens in senkrechter Richtung eingespart werden. Es ist offensichtlich, dass die Exzenterscheibenanordnung für beide Lösungen erhebliche Reduzierungen des zu evakuierenden Kammervolumens bei gleichbleibender Werkstückgröße ermöglicht.

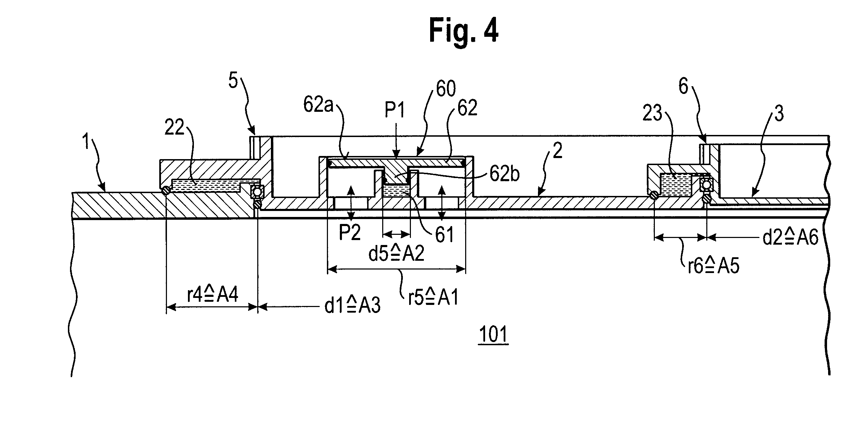

In der Fig. 4 ist eine Ausführungsform einer Druckkompensationsvorrichtung für die Exzenterscheibenanordnung 200 gezeigt.

Die Idee der Druckkompensation liegt darin, dass durch den Differenzdruck ΔP zwischen dem Atmosphärendruck (erster Druck P1) und dem vergleichsweise geringen zweiten Druck P2 in der Vakuumkammer auf die Exzenterscheibenanordnung 200, und genauer auf die erste Abdeckung 2 und die zweite Abdeckung 3, eine große Druckkraft ausgeübt wird, die von der Fläche abhängt, auf die dieser Differenzdruck wirkt.

Bei der in Fig. 4 gezeigten Druckkompensationsvorrichtung ist an der ersten Abdeckung 2 und/oder an der zweiten Abdeckung 3 eine Gegendruckkammer 22 bzw. 23 vorgesehen. In den Gegendruckkammern (Hohlkammern) 22, 23 wirkt ein Druck Px auf die oberen Begrenzungsflächen der Gegendruckkammern. Bei der Gegendruckkammer 22 ist diese Fläche ein Ringabschnitt mit einer Ringstärke r4 und einer sich daraus ergebenden Ringfläche A4. Demgegenüber weist die Exzenterscheibenanordnung aus erster Abdeckung 2, zweiter Abdeckung 3 und Verschluss 10 eine Kreisfläche A3 auf, die sich aus dem Durchmesser d1 der ersten Abdeckung 2 ergibt. Auf die Fläche A1 wirkt der Differenzdruck ΔP, während auf die entsprechende Fläche der Gegendruckkammer 22 der Differenzdruck aus dem Druck Px und dem Atmosphärendruck P1 wirkt. Die Flächen A3 und A4 stehen in einem bestimmten Verhältnis zueinander.

Damit die Drehlagerung 5 entlastet wird, ist in der Gegendruckkammer 22 ein Gegendruck Px derart anzulegen, dass auf die Gegendruckfläche A4 eine Kraft wirkt, die kleiner gleich der aus dem ersten Differenzdruck ΔP resultierenden Druckkraft plus Gewichtskraft der Exzenterscheibenanordnung etc. entspricht. Das wird bei der in Fig. 4 gezeigten Ausführungsform in einfacher Weise durch einen Druckübersetzer 60 erreicht. Der Druckübersetzer 60 ist bei der gezeigten Ausführungsform auf der ersten Abdeckung 2 ausgebildet. Dazu ist auf der Oberseite der ersten Abdeckung 2 ein Ringflansch nach außen vorstehend vorgesehen, an dessen Innenseite ein tellerförmiger Kolben 62 senkrecht hin und her bewegbar ist. Der tellerförmige Kolben ist auf seiner Außenseite 62a mit dem Atmosphärendruck P1 beaufschlagt, und auf seiner Innenseite über Öffnungen in der ersten Abdeckung 2 mit dem zweiten Druck P2 in der Vakuumkammer 101. An der Unterseite des Kolbens 62 ist ein zylindrischer Fuß ausgebildet, der in einem zweiten ringförmigen Flansch mit kleinerem Durchmesser, der eine Fluidkammer 61 begrenzt, senkrecht hin und her bewegbar ist. Der tellerförmige Abschnitt des Kolbens 62 in dem größeren, äußeren Ringflansch sowie der Fuß in dem inneren, kleineren Ringflansch sind an ihren Außenseiten durch Dichtungen abgedichtet. Dadurch ergibt sich eine Fläche A1 des Kolbens, die mit dem ersten Differenzdruck ΔP beaufschlagt ist, die einen Ringabschnitt mit Ringstärke r5 entsprechend der Fläche A1 entspricht. Die Grundfläche des zylindrischen Fußes 62b mit einem Durchmesser d5 entspricht einer Fläche A2.

Das Verhältnis A1/A2 wird nun so gewählt, dass das Verhältnis A3/A4 größer oder gleich dem Verhältnis A1/A2 ist. Bei Gleichheit der beiden Verhältnisse wird die Druckkraft exakt ausgeglichen, und die Lager 5 werden ausschließlich mit dem Eigengewicht der Exzenterscheibenanordnung belastet.

Es wäre auch möglich, das Verhältnis A1/A2 leicht größer als das Verhältnis A3/A4 zu wählen, um auch einen Teil des Eigengewichtes der Exzenterscheibenanordnung auszugleichen.

Die zweite Abdeckung mit Verschluss 10 weist wiederum den Durchmesser d2 der zweiten Abdeckung 3 auf, was wiederum einer Fläche A6 entspricht. Die Gegendruckfläche der Gegendruckkammer 23 entspricht wiederum einem Ringabschnitt mit Ringstärke r6, was einer Fläche A5 entspricht. Das Verhältnis A1/A2 in Relation zum Verhältnis A5/A6 ist analog einzustellen. Wenn die Gegendruckkammern bei beiden Abdeckungen 2, 3 vorgesehen sind, dann sollten die Verhältnisse A3/A4 und A5/A6 im Wesentlichen identisch sein, falls nur ein Druckübersetzer 60 verwendet werden soll.

Alternativ ist es natürlich möglich, das Fluid für die Gegendruckkammer(n) auch anders als mit einem Druckübersetzer, z.B. einer normalen Pumpe, unter Druck zu setzen.

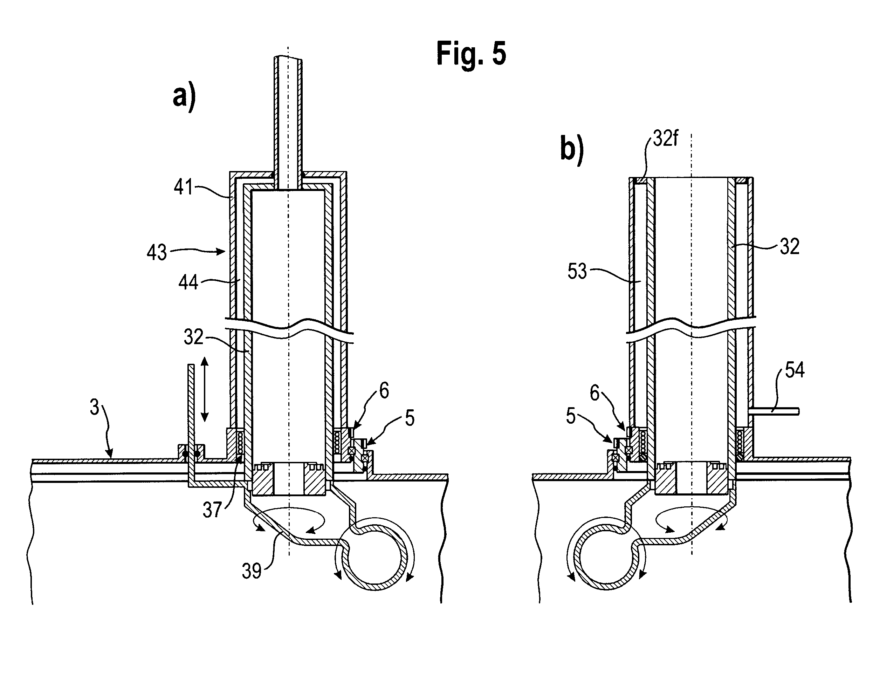

In Fig. 5 ist eine Ausführungsform mit einer Reduzierung der Druckkraft, die auf das Vertikalfahrwerk (das Rohr 32) zum vertikalen Verfahren des Elektronenstrahlgenerators 7 wirkt, gezeigt. Dazu ist das Rohr 32 an seiner Oberseite im Wesentlichen, bis auf eine Öffnung mit reduziertem Durchmesser, auf die ein Rohr 41 mit reduziertem Durchmesser aufgesetzt ist, geschlossen. Eine Druckkammer 44 ist auf der Oberseite der zweiten Abdeckung 3 vorgesehen. Die Druckkammer 43 umschließt das Rohr 32 auf der Oberseite der zweiten Abdeckung 3, bis auf eine Öffnung, durch die das Rohr 41 nach oben austreten kann. Diese Öffnung ist vakuumdicht gedichtet. Dadurch herrscht in der Kammer 44 der Kammerdruck, und der Differenzdruck wirkt nur auf eine Fläche, die der Grundfläche des Rohres 41 entspricht.

Dadurch können die Anforderungen an die Dichtung der Linearführung für das Rohr 32 reduziert werden. Bei der in Fig. 5a) gezeigten Ausführungsform ist der Antrieb zum vertikalen Verfahren des Rohrs 32 separat abgedichtet.

Bei der in Fig. 5b) gezeigten Ausführungsform ist eine Druckkompensation vorgesehen. Dabei ist die Außenfläche des zylindrischen Rohres 32 von einer Ringkammer 53 umgeben, die durch einen Anschluss 54 mit Überdruck, zum Beispiel durch Druckluft, beaufschlagt werden kann. An der Oberseite des Rohres 32 ist ein Ringflansch 32f mit Dichtung vorgesehen, um die Kammer 53 an der Oberseite zu schließen.

Fig. 6 zeigt eine Schnittansicht eines Teils einer Ausführungsform einer Teilchenstrahlbearbeitungsvorrichtung, die eine Modifikation der Teilchenstrahlbearbeitungsvorrichtung aus Fig. 3 ist. Gleiche Teile sind mit gleichen Bezugsziffern versehen.

Im Unterschied zu der Ausführungsform aus Fig. 3 ist bei der in Fig. 6 gezeigten Ausführungsform der Elektronenstrahlgenerator 7 nicht über die Dreh- und Schwenkvorrichtung 39 an dem Rohr 32 befestigt, sondern in dem Inneren des Rohrs 32 angeordnet. Dabei ist der Elektronenstrahlgenerator 7 vakuumdicht auf einem Ende eines ringförmigen Rohrverschlusses 47 aufgesetzt, der an seiner Außenseite einen Flansch 47f aufweist, der denselben Durchmesser wie den Außendurchmesser des Rohrs 32 aufweist und vakuumdicht mit der kammerseitigen Stirnfläche des Rohrs 32 verbunden ist. In einer Öffnung des ringförmigen Rohrverschlusses 47 ist der Teil des Elektronenstrahlgenerators 7, aus dem der Elektronenstrahl austritt, aufgenommen. Bei diesem Aufbau befindet sich lediglich dieser Teil des Elektronenstrahlgenerators 7 in dem in der Vakuumkammer herrschenden Vakuum. Der restliche Teil des Elektronenstrahlgenerators 7, insbesondere ein Hauptkörper des Elektronenstrahlgenerators sowie der Anschlussbereich für Zufuhrleitungen 57 zu dem Elektronenstrahlgenerator 7, befindet sich in einem Aufnahmeraum 37 im Inneren des Rohrs 32, der durch den Teilchengenerator 7 und den Rohrverschluss 47 verschlossen ist und in dem ein anderer Druck als der in der Vakuumkammer 101, beispielsweise Atmosphärendruck, herrscht. Durch das Rohr 32 kann der Elektronenstrahlgenerator über den Verfahrweg 11 in dem evakuierbaren Kammervolumen V der Vakuumkammer 101 verfahren werden, ohne dass er sich in dem in der Kammer herrschenden Vakuum befindet.

Zwischen dem Flansch 47f und dem kammerseitigen Ende des Rohrs 32 kann eine Dichtung vorgesehen sein. Der Rohrverschluss 47 kann auf verschiedene Arten fest oder lösbar mit dem Rohr 32 verbunden sein, beispielsweise durch Verschrauben, Vernieten, Einpressen, etc.

Der Elektronenstrahlgenerator muss nicht wie in Fig. 6 gezeigt vollständig im Inneren des Rohrs 32 angeordnet sein. Alternativ kann er sich teilweise innerhalb und teilweise außerhalb des Rohrs 32 befinden, solange der innerhalb des Rohrs 32 angeordnete Teil des Elektronenstrahlgenerators 7 gegenüber dem Kammerinneren abgedichtet ist. Ferner kann der Durchmesser des Ringflansches 47f gleich dem Innendurchmesser des Rohrs 32 sein und mit der Innenseite des Rohrs 32 vakuumdicht verbunden sein. Der Verschluss 47 kann auch weggelassen sein. In diesem Fall verschließt der Elektronenstrahlgenerator 7 selbst das kammerseitige Ende des Rohrs 32, beispielsweise indem er den Flansch 47f aufweist.

Die in Fig. 6 gezeigte Ausführungsform kann optional mit einem oder mit mehreren der Merkmale, die im Vorhergehenden unter Bezugnahme auf die Figuren 1 bis 5 beschrieben wurden, kombiniert werden. Beispielsweise kann das Druckausgleichmittel für die Abdeckungen 2, 3 aus Fig. 4, eine der in Fig. 5 gezeigten Einrichtungen zur Druckkompensation für das Rohr 32, das in Fig. 2 gezeigte Begrenzungsmittel mit der Führungsstange 11 oder eine Kombination derselben vorgesehen sein. Die Nut 321 sowie der Stift 36 können auch weggelassen sein.

Bei der Ausführungsform, die in Fig. 6 gezeigt ist, ist das Rohr 32 in der Öffnung der zweiten Abdeckung 3 der Exzenterscheibenanordnung angebracht. Alternativ kann jedoch die Exzenterscheibenanordnung weggelassen sein und das Rohr 32 kann auf die vorher beschriebene Weise direkt in einer Kammerwandöffnung, die in einer der Wände der Vakuumkammer 101 ausgebildet ist, angebracht sein. Dann kann der Elektronenstrahlgenerator ebenfalls über den Verfahrweg 11 in dem Kammervolumen V verfahren werden, ohne dass er sich in dem in der Kammer herrschenden Vakuum befindet.

Anstelle des Rohrs 32 können auch andere geeignete Teile/Elemente einer Linearbewegungsvorrichtung wie beispielsweise eine Stange oder eine Teleskopanordnung vorgesehen sein. Ferner muss die entsprechende Linearbewegungsvorrichtung den Teilchenstrahlgenerator nicht durch eine Öffnung in der Kammerwand verfahren, sondern sie kann sich innerhalb der Vakuumkammer befinden, zum Beispiel indem sie an einer Innenseite einer Kammerwand oder einer Abdeckung einer Exzenterscheibenanordnung angebracht ist.

Bei den vorher beschriebenen Ausführungsformen der Teilchenstrahlbearbeitungsvorrichtung kann mittels zweier exzentrisch angeordneter kreisförmiger Abdeckungen 2, 3 der gesamte Arbeitsbereich R abgedeckt werden, wie in Fig. 2 gezeigt ist. Dazu ist es erforderlich, dass der Abstand C1C2 zwischen der ersten Drehachse C1 und der zweiten Drehachse C2 gleich dem Abstand C2C3 zwischen der zweiten Drehachse C2 und der dritten Drehachse C3 ist, die zugleich die Strahlachse des von dem Teilchenstrahlgenerator 7 erzeugten Teilchenstrahls ist.

Bei dieser Konstruktion ist zum Bewegen des Teilchenstrahlgenerators in der Nähe des Zentrums des Arbeitsbereiches R, d.h. in der Nähe der ersten Drehachse C1, eine hohe Dreh- bzw. Winkelgeschwindigkeit der ersten, großen Abdeckung 2 erforderlich, da insbesondere zur geradlinigen Bewegung des Teilchenstrahlgenerators durch das Zentrum oder in der Nähe des Zentrums beide Abdeckungen gleichzeitig bewegt werden müssen, wobei eine relativ kleine Drehung der zweiten Abdeckung 3 eine relativ große Drehung der ersten Abdeckung 2 erfordert.

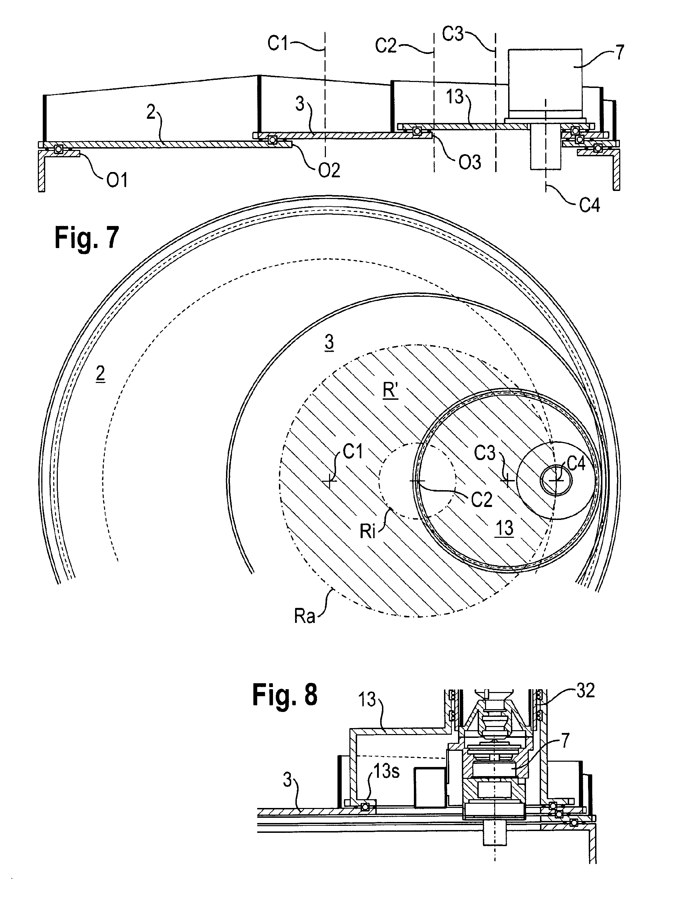

Bei der in Fig. 7 gezeigten Ausführungsform ist keine hohe Winkelgeschwindigkeit zum Bewegen des Teilchenstrahlgenerators in der Nähe des Zentrums der ersten Abdeckung 2 erforderlich. Die in Fig. 7 gezeigte Ausführungsform ist eine Modifikation der vorher beschriebenen Ausführungsformen, weshalb im Anschluss lediglich die Unterschiede zu diesen Ausführungsformen beschrieben sind. Gleiche Teile sind mit gleichen Bezugszeichen versehen.

Die in der zweiten Abdeckung 3 ausgebildete Öffnung 03 wird bei dieser Ausführungsform von einer kreisförmigen dritten Abdeckung 13 abgedeckt. Die gemeinsame Mittelachse der dritten Öffnung 03 und der dritten Abdeckung 13 ist mit C3 bezeichnet. Die dritte Drehachse C3 ist in einem Abstand C2C3 von der zweiten Drehachse C2 angeordnet. Die Achse C3 ist die Drehachse der dritten Abdeckung 13, die als eine Drehscheibe ausgebildet ist. Auf der dritten Abdeckung C3 ist exzentrisch ein Teilchenstrahlgenerator 7 aufgesetzt, wie in Fig. 7 schematisch gezeigt ist. Der Teilchenstrahlgenerator 7 kann beispielsweise wie in Fig. 2 gezeigt in einer Öffnung in der dritten Abdeckung 13 angebracht sein. Der Teilchenstrahlgenerator 7 kann ebenfalls auf andere Weise an der dritten Abdeckung 13 angebracht sein, insbesondere kann er wie vorher beschrieben in dem evakuierbaren Kammervolumen V verfahrbar sein. Die Mittelachse des Teilchenstrahlgenerators 7 bzw. die Strahlachse des Teilchenstrahls ist mit C4 bezeichnet. Die Achse C4 ist parallel zu der Achse C3 und weist einen Abstand C3C4 zu derselben auf.

Es sei bemerkt, dass sich bei der in Fig. 7 gezeigten Ausführungsform die jeweiligen Lagerungen und Dichtungen zwischen der Kammerwand und der ersten Abdeckung bzw. zwischen den jeweiligen Abdeckungen nicht zwischen Flanschen befinden, die an den Abdeckungen bzw. an der Kammerwand ausgebildet sind, sondern dass sie auf bekannte Weise zwischen der Oberseite der Kammerwand und der Unterseite der ersten Abdeckung 2, die einen größeren Durchmesser als die erste Öffnung O1 aufweist, zwischen der Oberseite der ersten Abdeckung 2 und der Unterseite der zweiten Abdeckung 3, die einen größeren Durchmesser als die zweite Öffnung 02 aufweist, und zwischen der Oberseite der zweiten Abdeckung 3 und der Unterseite der dritten Abdeckung 13, die einen größeren Durchmesser als die dritte Öffnung 03 aufweist, angeordnet sind. Natürlich kann eine derartige Lagerung der Abdeckungen auch in Verbindung mit einem der vorher beschriebenen Ausführungsbeispiele verwendet werden, und ebenso können bei der Ausführungsform in Fig. 7 Flansche vorgesehen sein.

In Fig. 7 ist der Abstand C2C3 gleich dem Abstand C1C2. Der Teilchenstrahlgenerator 7 ist in einem Abstand C3C4 von der Mittelachse C3 auf der dritten Abdeckung 13 angeordnet. Der Abstand C3C4 ist bei diesem Beispiel kleiner als die Abstände C1C2 und C2C3. Der Abstand C3C4 kann jedoch auch größer oder gleich den Abständen C1C2 und C2C3 sein, sofern die Abmessungen der drei Abdeckungen und der zugehörigen Öffnungen dies erlauben. Bei einer Drehung der dritten Abdeckung 13 beschreibt die Strahlachse C4 des Teilchenstrahlgenerators 7 eine Kreisbahn. Eine Rotation dieser Kreisbahn um die Mittelachse C2 bei einer Drehung der zweiten Abdeckung 3 liefert einen schraffierten Arbeitsbereich R', der bei unveränderter Position der zweiten Abdeckung 3 durch Drehung der zweiten Abdeckung 3 und der dritten Abdeckung 13 abgedeckt werden kann. Wie aus Fig. 7 ersichtlich ist, liegt dabei das Zentrum C1 der äußeren Abdeckung 2 innerhalb des Arbeitsbereiches R'. D.h., zum Bewegen des Teilchenstrahlgenerators bzw. der Strahlachse C4 in der Nähe des Zentrums C1 reicht es aus, lediglich die Abdeckungen 3, 13 zu drehen, mit relativ niedrigen Winkelgeschwindigkeiten. Der sich ergebende Arbeitsbereich R' hat die Form eines Kreisringes mit einem Innendurchmesser Ri und einem Außendurchmesser Ra. Durch eine Rotation dieses Kreisringes um die Mittelachse C1 bei einer Drehung der ersten Abdeckung 2 kann der gesamte Arbeitsbereich abgedeckt werden, d.h. ein Kreis mit Mittelpunkt C1 und Radius C1C4, analog zu dem in Fig. 2 gezeigten Arbeitsbereich R.

Die dritte Abdeckung 13 muss keine flache Drehscheibe sein. Fig. 8 zeigt eine alternative Ausführung der dritten Abdeckung 13. Dabei weist die Abdeckung 13 eine sich senkrecht von einem äußeren, scheibenartigen Abschnitt 13s erstreckende Kammerwand, die eine Kammer zur Aufnahme eines Teilchenstrahlgenerators 7 und einer vorher beschriebenen Linearbewegungsvorrichtung 32 begrenzt, auf. Die Kammer zur Aufnahme des Generators 7 und der Linearbewegungsvorrichtung 32 ist ähnlich zu der in Fig. 5a gezeigten Kammer 43 aufgebaut. D.h., die Linearbewegungsvorrichtung 32 und der Teilchenstrahlgenerator 7 befinden sich in dem in der Vakuumkammer herrschenden Vakuum, und die Abdichtung gegenüber der Atmosphäre erfolgt in einem (nicht gezeigten) oberen Abschnitt der Abdeckung 13. Der in der dritten Abdeckung ausgebildete Aufnahmeraum ermöglicht beispielsweise die Aufnahme eines über eine Schwenkvorrichtung an dem Ende der Linearbewegungsvorrichtung angebrachten Generators oder einer an dem Generator angebrachten zusätzlichen Pumpe. Eine derartig ausgebildete Abdeckung kann auch als eine Abdeckung für alle anderen hierin beschriebenen Ausführungsformen verwendet werden.

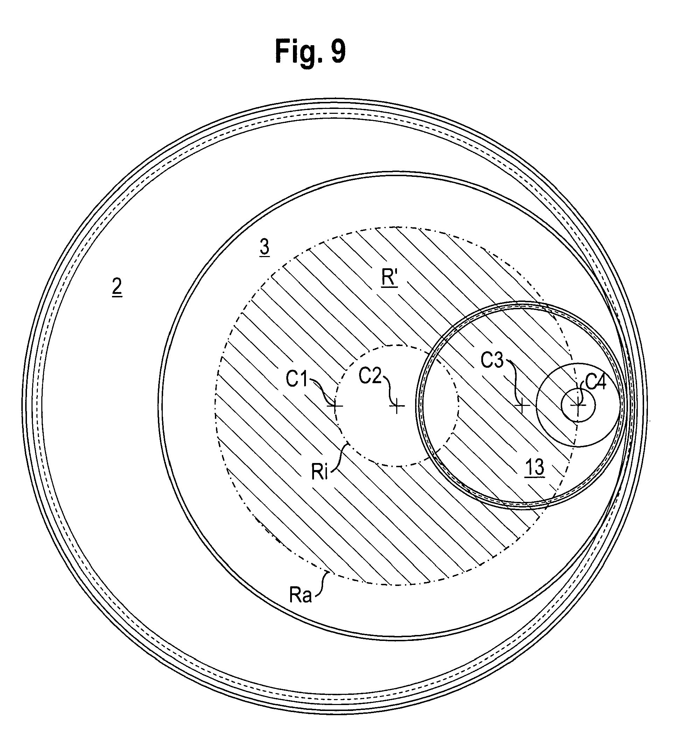

Fig. 9 zeigt eine alternative Ausführungsform der Exzenterscheibenanordnung mit den drei Scheiben 2, 3, und 13. In Fig. 9 sind die Scheiben bzw. Abstände derart ausgebildet, dass der Abstand C1C2 gleich dem Abstand C2C3 minus den Abstand C3C4 ist. Demzufolge hat der Arbeitsbereich R' bei einer vorgegebenen Position der zweiten Abdeckung 3 die Form eines Kreisrings mit einem Mittelpunkt C2, einem Innenradius Ri = C1C2 und einem Außenradius Ra = C2C4. Das Zentrum C1 liegt am inneren Rand des Arbeitsbereichs R'. Zur Bewegung des Teilchenstrahls in der Nähe des Zentrums C1 kann deshalb eine Drehung der äußersten Abdeckung 2 erforderlich sein, wobei jedoch das Auftreten hoher Winkelgeschwindigkeiten ebenfalls vermieden werden kann.

Die in den Fig. 7 und 9 gezeigten Ausführungsformen sind lediglich beispielhaft. Allgemein ist es zur Vermeidung hoher Winkelgeschwindigkeiten, insbesondere der äußersten Abdeckung 2, bei einer Bewegung des Teilchenstrahlgenerators in der Nähe des Zentrums ausreichend, dass das Zentrum C1 innerhalb des Arbeitsbereichs R', der durch eine Bewegung der zweiten Abdeckung 3 und der dritten Abdeckung 13 abgedeckt wird, liegt und nicht mit dem Außenradius Ra des Arbeitsbereichs R' zusammenfällt. Dies bedeutet, dass für die Abstände C 1 C2 < C2C3 + C3C4 gelten muss. Es ist von Vorteil, wenn das Zentrum C1 nicht zu nahe an dem Außenradius Ra des Kreisrings liegt. Bevorzugt ist, dass der Abstand C2C3 + C3C4 - C1C2 zwischen dem Zentrum C1 und dem Rand des Arbeitsbereichs R' mindestens 10% des Durchmessers des Arbeitsbereichs R' (festgelegt durch Ra = C2C3 + C3C4) beträgt. Noch bevorzugter ist, dass ein Verhältnis x = (C2C3 + C3C4 - C1C2)/(C2C3 + C3C4) zwischen 0,2 und 0,8 liegt. Besonders bevorzugt ist, dass, wie beispielsweise in Fig. 7 gezeigt, 0,3 ≤ x ≤ 0,6 ist. Bei der in Fig. 7 gezeigten Ausführungsform ist C1C2 = C2C3 und das Zentrum C1 befindet sich in der Mitte des Kreisrings R'.

Die Begrenzung der Winkelgeschwindigkeiten kann bei einigen der hierin beschriebenen Ausführungsformen und deren Modifikationen auch ohne Verwendung einer dritten Abdeckung 13 erzielt werden. Beispielsweise weist bei der in Fig. 3 gezeigten Ausführungsform die Schwenkachse X den gleichen Abstand zu der dritten Drehachse C3 auf wie die Strahlachse des Teilchenstrahlgenerators 7. D.h., die in den Fig. 7 und 9 gezeigten Draufsichten sind auch auf diese Ausführungsform anwendbar, wobei die Position der Schwenkachse X der Position der Achse C4 entspricht. Entscheidend ist, dass der Teilchenstrahlgenerator 7 in einem Abstand C3C4 bzw. C3X um die dritte Drehachse C3 gedreht wird. Dies kann durch eine beliebige Generator-Dreheinrichtung geschehen, beispielsweise durch die in den Fig. 7 und 9 gezeigte dritte Scheibe 13 oder die in Fig. 3 gezeigte Dreh- und Schwenkvorrichtung 39.

Die in den Fig. 7 und 9 gezeigten Ausführungsformen haben den Vorteil, dass die gewünschte Wirkung auch dann erzielt werden kann, wenn keine Dreh- und Schwenkvorrichtung für den Generator 7 vorgesehen ist, beispielsweise wenn der Generator 7 auf der Außenseite der Vakuumkammer positioniert ist oder wenn er wie bei der in Fig. 6 gezeigten Ausführungsform in bzw. an dem Rohr 32 angebracht ist.

Die in den Fig. 7 und 9 gezeigten Ausführungsformen können mit beliebigen der im Zusammenhang mit den vorher beschriebenen Ausführungsformen offenbarten Merkmale kombiniert werden. Beispielsweise kann zusätzlich zur dritten Abdeckung 13 die Dreh- und Schwenkvorrichtung 39 vorgesehen sein, um einen zusätzlichen Freiheitsgrad der Drehung des Teilchenstrahlgenerators 7 zu liefern. Wahlweise kann die Dreh- und Schwenkvorrichtung 39 lediglich als eine Schwenkvorrichtung ausgebildet sein, die den Teilchenstrahlgenerator 7 um eine Schwenkachse X, die senkrecht zu der dritten Drehachse C3 ist, schwenken kann. Ferner kann der Teilchenstrahlgenerator 7 wie vorher beschrieben in dem evakuierbaren Kammervolumen V verfahrbar sein, unter Verwendung einer Linearbewegungsvorrichtung, die beispielsweise als ein Rohr 32 ausgebildet sein kann.

Weiter kann die Teilchenstrahlbearbeitungsvorrichtung, die in den Fig. 7 und 9 gezeigt ist, das vorher beschriebene Druckausgleichsmittel (siehe Fig. 4) für eine oder mehrere der ersten Abdeckung 2, der zweiten Abdeckung 3 und der dritten Abdeckung 13 aufweisen. Es kann ebenfalls ein Druckausgleichsmittel für den Generator 7 bzw. die Linearbewegungsvorrichtung 32 vorgesehen sein, wie es unter Bezugnahme auf Fig. 5 beschrieben wurde.

Die Ausführungsformen aus den Fig. 7 und 9 können weiter mit einem der vorher beschriebenen Begrenzungsmittel kombiniert werden, beispielsweise kann bei einem außen an der dritten Abdeckung 13 angebrachten Generator die Führungsstange 11 aus Fig. 2 vorgesehen sein. Wenn eine Linearbewegungsvorrichtung 32 für den Generator 7 vorgesehen ist, kann das in den Fig. 3 und 6 gezeigte Begrenzungsmittel 36 verwendet werden. Für die erste Abdeckung 2, die zweite Abdeckung 3, die dritte Abdeckung 13 und eine optionale Linearbewegungseinrichtung 32 können entsprechende Antriebsmotoren vorgesehen sein.

Für eine erhöhte Flexibilität bei einer Teilchenstrahlbearbeitung kann in der Vakuumkammer 101 eine drehbare und/oder schwenkbare und/oder verschiebbare Aufnahme für das Werkstück vorgesehen sein, die das Werkstück gesteuert durch eine Steuervorrichtung drehen und/oder schwenken und/oder verschieben kann.

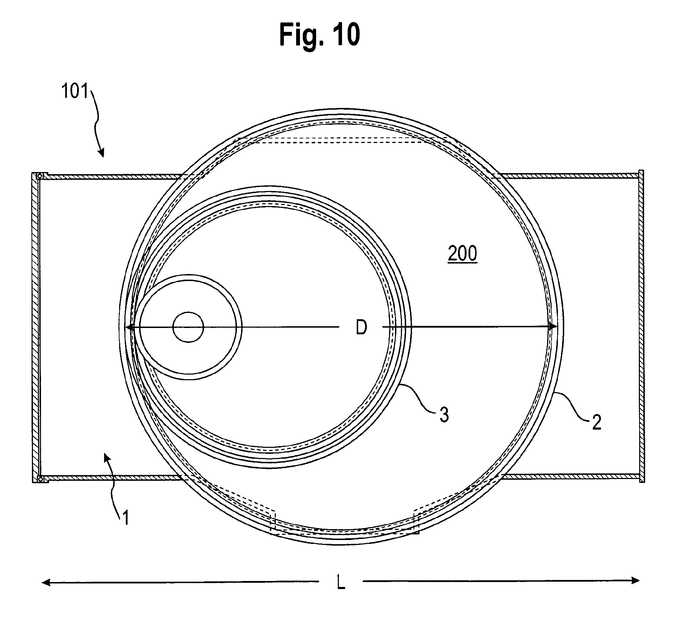

Insbesondere kann die Vakuumkammer zur Aufnahme und Bearbeitung langer Werkstücke, die eine im Vergleich zu ihrer Länge deutlich geringere Breite aufweisen, angepasst sein. Dazu kann die Vakuumkammer verlängert sein, so dass eine Länge L der Vakuumkammer 101 deutlich größer als der Durchmesser D der äußersten Abdeckung 2 bzw. der gesamten Exzenterscheibenanordnung 200 ist, wie in Fig. 10 gezeigt ist. Dabei ist der Mittelpunkt der Abdeckung 2 in der Längsrichtung der Vakuumkammer 101 vorzugsweise im Wesentlichen in der Mitte angeordnet ist. Bevorzugt ist, dass für das Verhältnis y = L/D gilt, dass 1,2 ≤ y ≤ 5 ist. Noch bevorzugter ist, dass 1,5 ≤ y ≤ 3 ist. Zum Bearbeiten des Werkstücks über der gesamten Länge kann eine linear verschiebbare Verfahrvorrichtung für das Werkstück in der Kammer vorgesehen sein. Die Vakuumkammer 101 kann im Querschnitt eine andere als eine Rechtecksform aufweisen.

## Patentansprüche

1. Teilchenstrahlbearbeitungsvorrichtung mit
einem Teilchenstrahlgenerator (7),
einer von Kammerwänden (1, 102, 103, 104, 105) begrenzten Vakuumkammer (101), wobei eine der Kammerwände eine erste Öffnung (O1), die in der Kammerwand (1) ausgebildet ist, aufweist,
einer ersten Abdeckung (2), die dazu angepasst ist, die erste Öffnung (O1) abzudecken und um eine erste Drehachse (C1), die durch die erste Öffnung (O1) geht, gedreht zu werden, und die eine zweite Öffnung (02), die in der ersten Abdeckung (2) ausgebildet ist, aufweist, und einer zweiten Abdeckung (3), die dazu angepasst ist, die zweite Öffnung (02) abzudecken und um eine zweite Drehachse (C2), die durch die zweite Öffnung (02) geht, gedreht zu werden und den Teilchenstrahlgenerator (7) zu bewegen, **gekennzeichnet durch**
eine Linearbewegungsvorrichtung (31-35), die dazu angepasst ist, den Teilchenstrahlgenerator (7) in dem **durch** die Kammerwände (1, 102, 103, 104, 105) begrenzten Raum in einer ersten Richtung (Z) linear zu verfahren.

2. Teilchenstrahlbearbeitungsvorrichtung nach Anspruch 1, bei der die erste Abdeckung (2) dazu angepasst ist, die erste Öffnung (O1) dichtend abzudecken, und die zweite Abdeckung (3) dazu angepasst ist, die zweite Öffnung (02) dichtend abzudecken.

3. Teilchenstrahlbearbeitungsvorrichtung nach Anspruch 1 oder 2, bei der der Teilchenstrahlgenerator (7) in einer Nullstellung außerhalb des durch die Kammerwände begrenzten Raums angeordnet ist und aus der Nullstellung in der ersten Richtung (Z) in dem durch die Kammerwände begrenzten Raum verfahrbar ist.

4. Teilchenstrahlbearbeitungsvorrichtung nach Anspruch 1 oder 2, bei der der Teilchenstrahlgenerator (7) in einer Nullstellung innerhalb des durch die Kammerwände begrenzten Raums angeordnet ist und aus der Nullstellung in der ersten Richtung (Z) in dem durch die Kammerwände begrenzten Raum verfahrbar ist.

5. Teilchenstrahlbearbeitungsvorrichtung nach einem der Ansprüche 1 bis 4, bei der die Linearbewegungsvorrichtung (31-35) dazu angepasst ist, den Teilchenstrahlgenerator (7) durch die zweite Öffnung (02) in der ersten Richtung (Z) in dem durch die Kammerwände begrenzten Raum zu verfahren.

6. Teilchenstrahlbearbeitungsvorrichtung nach Anspruch 5, bei der die Linearbewegungsvorrichtung (31-35) ein Rohr (32) aufweist, das in der ersten Richtung (Z) in dem durch die Kammerwände begrenzten Raum verfahrbar ist und an dessen kammerseitigem Ende der Teilchenstrahlgenerator (7) angebracht ist.

7. Teilchenstrahlbearbeitungsvorrichtung nach Anspruch 6, bei der das Rohr (32) einen Aufnahmeraum (37) aufweist und der Teilchenstrahlgenerator (7) wenigstens teilweise in dem Aufnahmeraum (37) aufgenommen ist und diesen gegenüber dem durch die Kammerwände begrenzten Raum verschließt.

8. Teilchenstrahlbearbeitungsvorrichtung nach einem der Ansprüche 1 bis 6, bei der die zweite Abdeckung (3) dazu angepasst ist, eine Generator-Dreheinrichtung (13; 39), die dazu angepasst ist, den Teilchenstrahlgenerator (7) um eine dritte Drehachse (C3), die durch die zweite Abdeckung (3) geht, zu drehen, zu bewegen.

9. Teilchenstrahlbearbeitungsvorrichtung nach Anspruch 8, bei der der Teilchenstrahlgenerator (7) dazu angepasst ist, einen Teilchenstrahl mit einer Strahlachse (C4), die parallel zu der ersten Drehachse (C1), der zweiten Drehachse (C2) und der dritten Drehachse (C3) ist, zu erzeugen, wobei ein erster Abstand zwischen der ersten Drehachse (C1) und der zweiten Drehachse (C2) gleich C1C2 ist, ein zweiter Abstand zwischen der zweiten Drehachse (C2) und der dritten Drehachse (C3) gleich C2C3 ist und ein dritter Abstand zwischen der dritten Drehachse (C3) und der Strahlachse (C4) gleich C3C4 ist, und C1C2 < C2C3 + C3C4 ist.

10. Teilchenstrahlbearbeitungsvorrichtung nach Anspruch 9, bei der für ein Verhältnis x = (C2C3 + C3C4 -C1C2)/(C2C3 + C3C4) gilt, dass 0,2 ≤ x ≤ 0,8 ist.

11. Teilchenstrahlbearbeitungsvorrichtung nach einem der Ansprüche 8 bis 10, bei der die Generator-Dreheinrichtung (13; 39) eine dritte Abdeckung (13), die dazu angepasst ist, eine in der zweiten Abdeckung (3) ausgebildete dritte Öffnung (03), durch die die dritte Drehachse (C3) geht, abzudecken, aufweist.

12. Teilchenstrahlbearbeitungsvorrichtung nach einem der Ansprüche 8 bis 11, bei der die Generator-Dreheinrichtung (13; 39) eine Dreh-Schwenkvorrichtung (39), die dazu angepasst ist, den Teilchenstrahlgenerator (7) um eine Schwenkachse (X), die senkrecht zu der dritten Drehachse (C3) ist, zu schwenken, aufweist.

13. Teilchenstrahlbearbeitungsvorrichtung nach einem der vorhergehenden Ansprüche, bei der ein Druckausgleichsmittel vorgesehen ist, das dazu angepasst ist, eine aus einer Druckdifferenz (ΔP) zwischen einem ersten Druck (P1) außerhalb des evakuierbaren Kammervolumens (V) und einem zweiten Druck (P2) in dem evakuierbaren Kammervolumen (V) resultierende Kraft zu vermindern oder auszugleichen.

14. Teilchenstrahlbearbeitungsvorrichtung nach Anspruch 13, bei der das Druckausgleichmittel einen Druckübersetzer (60), der eine Fluidkammer (61) und einen Kolben (62), der in der Fluidkammer bewegbar ist, aufweist, bei dem der bewegbare Kolben (62) eine erste Kolbenfläche (62a), auf die die Druckdifferenz (ΔP) zwischen dem ersten Druck (P1) und dem zweiten Druck (P2) wirkt, und eine zweite Kolbenfläche (62b), auf die ein Druck in der Fluidkammer (61) wirkt, aufweist, und bei dem die erste Kolbenfläche (62a) und die zweite Kolbenfläche (62b) in einem ersten Verhältnis (A1/A2) zueinander stehen, und das Druckausgleichsmittel einen ersten Hohlraum (22), der eine erste Druckaufnahmefläche (A4) an der ersten Abdeckung (2) festlegt, und/oder einen zweiten Hohlraum (23), der eine zweite Druckaufnahmefläche (A5) an der zweiten Abdeckung (3) festlegt, aufweist, und die Fluidkammer (61) mit dem ersten Hohlraum (22) und/oder dem zweiten Hohlraum (23) in Fluidverbindung steht und ein zweites Verhältnis (A3/A4) der Fläche (A3) der ersten Abdeckung (2), die der Druckdifferenz (ΔP) ausgesetzt ist, zu der ersten Druckaufnahmefläche (A4) und/oder ein drittes Verhältnis (A6/A5) der Fläche (A6) der zweiten Abdeckung (3), die der Druckdifferenz (ΔP) ausgesetzt ist, zu der zweiten Druckaufnahmefläche (A5) größer oder gleich dem ersten Verhältnis (A1/A2) sind/ist.

15. Teilchenstrahlbearbeitungsvorrichtung nach einem der vorhergehenden Ansprüche, bei der die Vakuumkammer (101) in einer Längsrichtung eine erste Länge L aufweist, die erste Abdeckung (2) mit einem Durchmesser D in der Längsrichtung im Wesentlichen in der Mitte der Vakuumkammer (101) angeordnet ist und für ein Verhältnis y = L/D gilt, dass 1,2 ≤ y ≤ 5 ist.

## Claims

1. A particle beam processing device comprising
a particle beam generator (7),
a vacuum chamber (101) defined by chamber walls (1, 102, 103, 104, 105), wherein one of the chamber walls includes a first opening (01) formed in the chamber wall (1),
a first cover (2) that is adapted to cover the first opening (O1) and to be rotated about a first rotation axis (C1) passing through the first opening (01), and that includes a second opening (02) formed in the first cover (2), and
a second cover (3) that is adapted to cover the second opening (02) and to be rotated about a second rotation axis (C2) passing through the second opening (02) and to move the particle beam generator (7), **characterized by**
a linear movement device (31-35) adapted to linearly move the particle beam generator (7) in a first direction (Z) in the space defined by the chamber walls (1, 102, 103, 104, 105).

2. The particle beam processing device according to claim 1, wherein
the first cover (2) is adapted to seal the first opening (01), and
the second cover (3) is adapted to seal the second opening (02).

3. The particle beam processing device according to claim 1 or 2, wherein
the particle beam generator (7) is disposed outside the space defined by the chamber walls in a neutral position and movable from the neutral position in the space defined by the chamber walls in the first direction (Z).

4. The particle beam processing device according to claim 1 or 2, wherein
the particle beam generator (7) is disposed inside the space defined by the chamber walls in a neutral position and movable from the neutral position in the space defined by the chamber walls in the first direction (Z).

5. The particle beam processing device according to any one of claims 1 to 4, wherein
the linear movement device (31-35) is adapted to move the particle beam generator (7) through the second opening (02) in the space defined by the chamber walls in the first direction (Z).

6. The particle beam processing device according to claim 5, wherein
the linear movement device (31-35) includes a tube (32) that is movable in the first direction (Z) in the space defined by the chamber walls and that has the particle beam generator (7) attached to the same at its chamber-side end.

7. The particle beam processing device according to claim 6, wherein
the tube (32) includes an accommodation space (37), and the particle beam generator (7) is accommodated at least in part in the accommodation space (37) and closes the same with respect to the space defined by the chamber walls.

8. The particle beam processing device according to any one of claims 1 to 6, wherein
the second cover (3) is adapted to move a generator rotation means (13; 39) adapted to rotate the particle beam generator (7) about a third rotation axis (C3) passing through the second cover (3).

9. The particle beam processing device according to claim 8, wherein
the particle beam generator (7) is adapted to generate a particle beam having a beam axis (C4) that is parallel to the first rotation axis (C1), the second rotation axis (C2), and the third rotation axis (C3), wherein a first distance between the first rotation axis (C1) and the second rotation axis (C2) equals C1C2, a second distance between the second rotation axis (C2) and the third rotation axis (C3) equals C2C3, and a third distance between the third rotation axis (C3) and the beam axis (C4) equals C3C4, and C1C2 < C2C3 + C3C4.

10. The particle beam processing device according to claim 9, wherein, for a ratio x = (C2C3 + C3C4 - C1C2)/(C2C3 + C3C4), 0.2 ≤ x ≤ 0.8.

11. The particle beam processing device according to any one of claims 8 to 10, wherein the generator rotation means (13; 39) includes a third cover (13) adapted to cover a third opening (03) formed in the second cover (3), the third rotation axis (C3) passing through the third opening (03).

12. The particle beam processing device according to any one of claims 8 to 11, wherein the generator rotation means (13; 39) includes a rotation-pivoting device (39) adapted to pivot the particle beam generator (7) about a pivot axis (X) that is perpendicular to the third rotation axis (C3).

13. The particle beam processing device according to any one of the preceding claims, wherein a pressure compensation means is provided that is adapted to reduce or compensate a force resulting from a pressure difference (ΔP) between a first pressure (P1) outside the evacuation chamber volume (V) and a second pressure (P2) in the evacuation chamber volume (V).

14. The particle beam processing device according to claim 13, wherein
the pressure compensation means includes a pressure translator (60) having a fluid chamber (61) and a piston (62) that is movable in the fluid chamber, wherein the movable piston (62) includes a first piston surface (62a) on which the pressure difference (ΔP) between the first pressure (P1) and the second pressure (P2) acts, and a second piston surface (62b) on which the pressure in the fluid chamber (61) acts, the first piston surface (62a) and the second piston surface (62b) having a ratio (A1/A2) with respect to each other, and
the pressure compensation means has a first cavity (22) defining a first pressure receiving surface (A4) on the first cover (2) and/or a second cavity (23) defining a second pressure receiving surface (A5) on the second cover (3), and the fluid chamber (61) is in fluid communication with the first cavity (22) and/or the second cavity (23), and a second ratio (A3/A4) of the surface (A3) of the first cover (2) subjected to the pressure difference (ΔP) to the first pressure receiving surface (A4) and/or a third ratio (A6/A5) of the surface (A6) of the second cover (3) subjected to the pressure difference (ΔP) to the second pressure receiving surface (A5) are/is greater than or equal to the first ratio (A1/A2).

15. The particle beam processing device according to any one of the preceding claims, wherein the vacuum chamber (101) has a length (L) in a longitudinal direction, the first cover (2) having a diameter D is arranged substantially at the center of the vacuum chamber (101) in the longitudinal direction, and, for a ratio y = L/D, 1.2 ≤ y ≤ 5.

## Revendications

1. Dispositif d'usinage par faisceau particulaire avec
un générateur de faisceau particulaire (7),
une chambre de vide (101) délimitée par des parois de chambres (1, 102, 103, 104, 105), l'une des parois de chambre présentant une première ouverture (01) qui est réalisée dans la paroi de chambre (1),
un premier recouvrement (2) qui est adapté afin de recouvrir la première ouverture (O1) et d'être tourné autour d'un premier axe de rotation (C1) qui passe par la première ouverture (01), et qui présente une seconde ouverture (02) qui est réalisée dans le premier recouvrement (2), et un second recouvrement (3) qui est adapté afin de recouvrir la seconde ouverture (02) et d'être tourné autour d'un deuxième axe de rotation (C2) qui passe par la seconde ouverture (02) et de déplacer le générateur de faisceau particulaire (7), **caractérisé par** un dispositif de déplacement linéaire (31-35) qui est adapté afin de déplacer linéairement le générateur de faisceau particulaire (7) dans l'espace délimité par les parois de chambre (1, 102, 103, 104, 105) dans un premier sens (Z).

2. Dispositif d'usinage par faisceau particulaire selon la revendication 1, pour lequel le premier recouvrement (2) est adapté afin de recouvrir de manière étanche la première ouverture (01) et le second recouvrement (3) est adapté afin de recouvrir de manière étanche la seconde ouverture (02).

3. Dispositif d'usinage par faisceau particulaire selon la revendication 1 ou 2, pour lequel le générateur de faisceau particulaire (7) est agencé dans une position initiale en dehors de l'espace délimité par les parois de chambre et peut être déplacé de la position initiale dans le premier sens (Z) dans l'espace délimité par les parois de chambre.

4. Dispositif d'usinage par faisceau particulaire selon la revendication 1 ou 2, pour lequel le générateur de faisceau particulaire (7) est agencé dans une position initiale dans l'espace délimité par les parois de chambre et peut être déplacé de la position initiale dans le premier sens (Z) dans l'espace délimité par les parois de chambre.

5. Dispositif d'usinage par faisceau particulaire selon l'une quelconque des revendications 1 à 4, pour lequel le dispositif de déplacement linéaire (31-35) est adapté afin de déplacer le générateur de faisceau particulaire (7) par la seconde ouverture (02) dans le premier sens (Z) dans l'espace délimité par les parois de chambre.

6. Dispositif d'usinage par faisceau particulaire selon la revendication 5, pour lequel le dispositif de déplacement linéaire (31-35) présente un tube (32) qui peut être déplacé dans le premier sens (Z) dans l'espace délimité par les parois de chambre et sur l'extrémité côté chambre duquel est monté le générateur de faisceau particulaire (7).

7. Dispositif d'usinage par faisceau particulaire selon la revendication 6, pour lequel le tube (32) présente un espace de réception (37) et le générateur de faisceau particulaire (7) est reçu au moins en partie dans l'espace de réception (37) et le ferme par rapport à l'espace délimité par les parois de chambre.

8. Dispositif d'usinage par faisceau particulaire selon l'une quelconque des revendications 1 à 6, pour lequel le second recouvrement (3) est adapté afin de déplacer un dispositif de rotation de générateur (13 ; 39) qui est adapté afin de tourner le générateur de faisceau particulaire (7) autour d'un troisième axe de rotation (C3) qui passe par le second recouvrement (3).

9. Dispositif d'usinage par faisceau particulaire selon la revendication 8, pour lequel le générateur de faisceau particulaire (7) est adapté afin de générer un faisceau particulaire avec un axe de faisceau (C4) qui est parallèle au premier axe de rotation (C1), au deuxième axe de rotation (C2) et au troisième axe de rotation (C3), une première distance entre le premier axe de rotation (C1) et le deuxième axe de rotation (C2) étant égale à C1C2, une deuxième distance entre le deuxième axe de rotation (C2) et le troisième axe de rotation (C3) étant égale à C2C3 et une troisième distance entre le troisième axe de rotation (C3) et l'axe de faisceau (C4) étant égale à C3C4 et C1 C2 étant < C2 C3 + C3C4.

10. Dispositif d'usinage par faisceau particulaire selon la revendication 9, pour lequel il s'applique pour un rapport x = (C2C3 + C3C4 - C1C2)/(C2C3 + C3C4) que 0,2 est ≤ x ≤ 0,8.

11. Dispositif d'usinage par faisceau particulaire selon l'une quelconque des revendications 8 à 10, pour lequel le dispositif de rotation de générateur (13 ; 39) présente un troisième recouvrement (13) qui est adapté afin de recouvrir une troisième ouverture (03) réalisée dans le second recouvrement (3), par laquelle le troisième axe de rotation (C3) passe.

12. Dispositif d'usinage par faisceau particulaire selon l'une quelconque des revendications 8 à 11, pour lequel le dispositif de rotation de générateur (13 ; 39) présente un dispositif de pivotement et de rotation (39) qui est adapté afin de pivoter le générateur de faisceau particulaire (7) autour d'un axe de pivotement (X) qui est perpendiculaire au troisième axe de rotation (C3).

13. Dispositif d'usinage par faisceau particulaire selon l'une quelconque des revendications précédentes, pour lequel un moyen de compensation de pression est prévu, lequel est adapté afin de réduire ou compenser une force résultant d'une différence de pression (ΔP) entre une première pression (P1) en dehors du volume de chambre pouvant être évacué (V) et une seconde pression (P2) dans le volume de chambre (V) pouvant être évacué.

14. Dispositif d'usinage par faisceau particulaire selon la revendication 13, pour lequel le moyen de compensation de pression présente un dispositif multiplicateur de pression (60) qui présente une chambre de fluide (61) et un piston (62) qui peut être déplacé dans la chambre de fluide, pour lequel le piston mobile (62) présente une première surface de piston (62a), sur laquelle la différence de pression (ΔP) agit entre la première pression (P1) et la seconde pression (P2), et une seconde surface de piston (62b), sur laquelle une pression agit dans la chambre de fluide (61), et pour lequel la première surface de piston (62a) et la seconde surface de piston (62b) sont dans un premier rapport (A1/A2) et le moyen de compensation de pression présente un premier espace creux (22) qui détermine une première surface de réception de pression (A4) sur le premier recouvrement (2), et/ou un second espace creux (23) qui détermine une seconde surface de réception de pression (A5) sur le second recouvrement (3), et la chambre de fluide (61) est en liaison fluidique avec le premier espace creux (22) et/ou le second espace creux (23) et un deuxième rapport (A3/A4) entre la surface (A3) du premier recouvrement (2) qui est exposé à la différence de pression (ΔP), et la première surface de réception de pression (A4) et/ou un troisième rapport (A6/A5) entre la surface (A6) du second recouvrement (3) qui est exposé à la différence de pression (ΔP), et la seconde surface de réception de pression (A5) est/sont supérieur(s) ou égal/égaux au premier rapport (A1/A2).

15. Dispositif d'usinage par faisceau particulaire selon l'une quelconque des revendications précédentes, pour lequel la chambre de vide (101) présente dans un sens longitudinal une première longueur L, le premier recouvrement (2) est agencé avec un diamètre D dans le sens longitudinal sensiblement au milieu de la chambre de vide (101) et il s'applique pour un rapport y = UD que 1,2 est ≤ y ≤ 5.
